# FASCICULE DE BREVET EUROPEEN

(11) **EP 0 591 022 B1**
(45) Date de publication et mention de la délivrance du brevet: **18.01.1995**
(21) Numéro de dépôt: 93402229.4
(22) Date de dépôt: 14.09.1993
(51) Int. Cl.: H02M 3/07, G11C 16/06

(54) **Circuit élévateur de tension de type pompe de charge avec oscillateur bootstrappe**
Spannungserhöhungsschaltung des Ladungspumpen-Typs mit Bootstrap-Oszillator
Voltage boosting circuit of the charge pump type with bootstrap oscillator

(30) Priorité: 01.10.1992 FR 9211751
(43) Date de publication de la demande: 06.04.1994
(73) Titulaire: SGS-THOMSON MICROELECTRONICS S.A., 94250 Gentilly (FR)
(72) Inventeur: Kassapian, Christian, Cabinet Ballot-Schmit, F-75116 Paris (FR)
(74) Mandataire: Schmit, Christian Norbert Marie

(56) Documents cités:
- EP-A- 0 350 462
- EP-A- 0 445 083
- FR-A- 2 379 198

## Description

L'invention concerne les circuits électroniques alimentés par une tension Vcc et dans lesquels il est nécessaire de produire une tension supérieure à Vcc.

L'exemple typique est le cas des circuits intégrés incorporant des mémoires non volatiles utilisant des transistors à grille flottante : la programmation de ces mémoires exige une tension de programmation Vpp bien supérieure à la tension d'alimentation normale Vcc. Pour que l'utilisateur puisse utiliser sa mémoire avec une seule tension d'alimentation Vcc, on prévoit que le circuit intégré possède des moyens internes pour engendrer la tension Vpp à partir de Vcc. Typiquement, Vcc peut être de 5 volts ou même moins et Vpp de 15 volts ou plus. Dans le futur on cherchera même à avoir une tension Vcc inférieure à 2 volts, Vpp pouvant atteindre plus de 15 volts.

Le circuit qui va produire Vpp est un circuit élévateur de tension dont le principe est celui de la "pompe de charge".

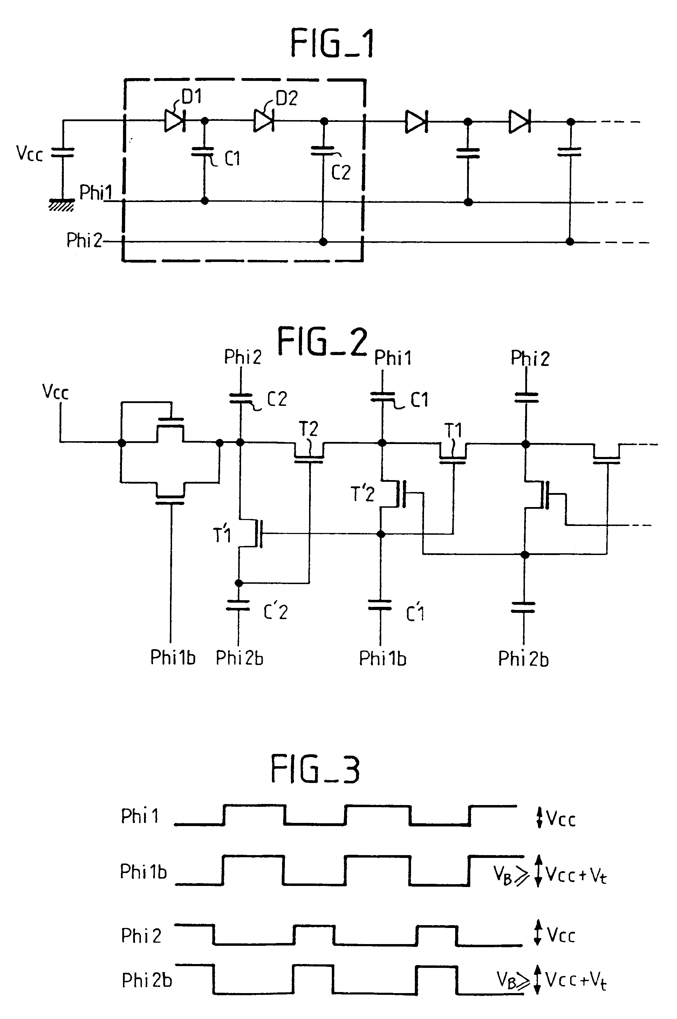

Le schéma de principe de la pompe de charge est représenté sur la figure 1. La pompe de charge comprend une succession d'étages de diodes et de capacités, avec des interrupteurs pour commuter les connexions des capacités entre Vcc et la masse selon deux phases périodiques Phi1, Phi2 non recouvrantes. Chaque étage comprend deux capacités C1, C2 et deux diodes D1, D2. Dans une première phase Phi1 la première capacité C1 est chargée à la tension d'alimentation Vcc. Dans une deuxième phase Phi2 elle est déchargée partiellement dans la deuxième capacité. Puis elle est à nouveau chargée (Phi1). Les diodes empêchent la décharge de la deuxième capacité, de sorte que progressivement celle-ci va voir sa charge croître jusqu'à une valeur qui peut dépasser Vcc (au maximum 2Vcc dans la théorie si on fait abstraction des chutes de tension dans les diodes).

Pour obtenir une tension plus élevée, on connecte en cascade n étages successifs. La tension obtenue peut être de (n+1)Vcc, ou plus exactement, en tenant compte de la tension de seuil Vd des diodes : (n+1) (Vcc-Vd).

Pour obtenir une valeur de tension de sortie suffisante sans augmenter trop le nombre n d'étages, on a déjà proposé de remplacer les diodes D1 et D2 par des transistors ne créant pas de chute de tension à leurs bornes lorsqu'ils sont conducteurs. Le schéma qui peut en résulter est celui de la figure 2. Comme les transistors ont également une tension de seuil Vt (tension minimale grille-source au dessous de laquelle ils ne conduisent pas) on prévoit que certains transistors ont leur grille commandée par un niveau de tension supérieur à (Vcc + Vt). Ainsi ils sont rendus conducteurs (sans chute de tension significative à leurs bornes) même si leur source et leur drain sont à Vcc, et on est libéré du problème de seuil. Avec n étages de pompe de charge on obtient alors une tension de sortie qui peut atteindre (n+1)Vcc, ce qui est plus favorable que dans les circuits à diodes. Mais cela suppose qu'on puisse commander les grilles de certains transistors à l'aide d'une tension légèrement supérieure à Vcc.

C'est pourquoi le schéma de pompe de charge de la figure 2 fait apparaître deux couples de signaux de commande : Phi1 et Phi2 d'une part comme à la figure 1, commutant entre deux niveaux de tension O et Vcc; Phi1b et Phi2b d'autre part, synchronisés respectivement avec Phi1 et Phi2 mais commutant entre deux niveaux de tension O et VB où VB est un niveau supérieur à Vcc, de préférence au moins égal à Vcc + Vt. La figure 3 représente schématiquement les phases de commutation de la pompe de charge de la figure 2.

Un paramètre important de la pompe de charge est sa "sortance", c'est-à-dire son aptitude à alimenter des charges plus ou moins importantes sans atténuation excessive de la tension de sortie. Or le calcul montre que la sortance est inversement proportionnelle au nombre d'étages de la pompe mais proportionnelle à la fréquence de commutation de la pompe, c'est-à-dire la fréquence des signaux Phi1, Phi2, Phi1b, Phi2b.

Il faut donc que la fréquence de commutation soit très stable ou en tout cas qu'elle diminue le moins possible lorsque le nombre d'étages de la pompe augmente. Il est souhaitable aussi qu'elle soit aussi stable que possible en fonction de la tension d'alimentation Vcc.

Pour produire les signaux de commande de commutation Phi1, Phi2, Phi1b, Phi2b, on a déjà proposé d'utiliser des circuits oscillateurs relativement complexes (EP-A-445083), qui présentent justement l'inconvénient d'être peu stables en fréquence d'une part par rapport aux variations de tension d'alimentation et d'autre part par rapport au nombre d'étages ou plus généralement à la constitution de la pompe de charge qu'ils commandent.

Les circuits utilisés dans la technique antérieure auront donc une fréquence de pompe de charge dépendant d'une manière non négligeable du nombre d'étages de la pompe de charge, ce qui rend la conception des circuits assez difficile et ne permet pas de prévoir des schémas de pompe de charge universels transposables d'un circuit à un autre.

Un but de l'invention est donc de prévoir un schéma de pompe de charge amélioré de ce point de vue.

Selon l'invention on propose une pompe de charge utilisant plusieurs étages à transistors et capacités avec un circuit de commande de commutation des transistors, caractérisée en ce que le circuit de commande de commutation comporte un oscillateur en anneau fournissant un signal à une fréquence F, suivi d'un étage de séparation de phases pour produire à partir de la sortie de l'oscillateur deux phases de commutation non recouvrantes, à la fréquence de l'oscillateur, le circuit de commande comportant en outre un premier étage de sortie pour fournir, à partir de signaux issus de l'étage de séparation, deux signaux Phi1 et Phi2 non recouvrants et commutant entre une tension 0 et une tension Vcc, et un deuxième étage de sortie bootstrapé pour fournir, à partir de signaux issus de l'étage de séparation, deux signaux Phi1b et Phi2b commutant sensiblement en synchronisme avec Phi1 et Phi2 mais entre une tension 0 et une tension VB supérieure à Vcc.

Alors que dans l'art antérieur on pouvait trouver des oscillateurs fournissant ces signaux Phi1, Phi2, Phi1b, Phi2b, ces oscillateurs ne séparaient pas les fonctions d'oscillation, de non-recouvrement et d'amplification de type bootstrap, de sorte que les fonctions de non-recouvrement et d'amplification bootstrap étaient insérées dans la boucle d'oscillation. Il en résultait une instabilité de fréquence que l'invention permet de corriger.

De préférence, l'oscillateur en anneau est un oscillateur à trois portes logiques seulement. L'une des portes peut être un inverseur à seuil. Ce type d'oscillateur, minimisant le nombre de portes logiques a l'avantage de produire une fréquence peu dépendante de la tension d'alimentation.

D'autres caractéristiques et avantages de l'invention apparaîtront à la lecture de la description détaillée qui suit et qui est faite en référence aux dessins annexés dans lesquels :
- la figure 1 représente une pompe de charge à diodes et capacités;
- la figure 2 représente une pompe de charge à transistors et capacités;
- la figure 3 représente les signaux de commutation associés à la pompe de charge de la figure 2;
- la figure 4 représente un circuit de commande de commutation selon l'invention;
- la figure 5 représente un schéma d'oscillateur utile pour la mise en oeuvre de l'invention;
- la figure 6 représente un schéma de circuit de séparation de phases utile pour la mise en oeuvre de l'invention;
- la figure 7 représente un schéma des étages de sortie bootstrapés et non bootstrapés, pouvant être utilisés dans le circuit de commande de commutation selon l'invention.
- la figure 8 représente les signaux logiques en différents points du circuit selon l'invention.

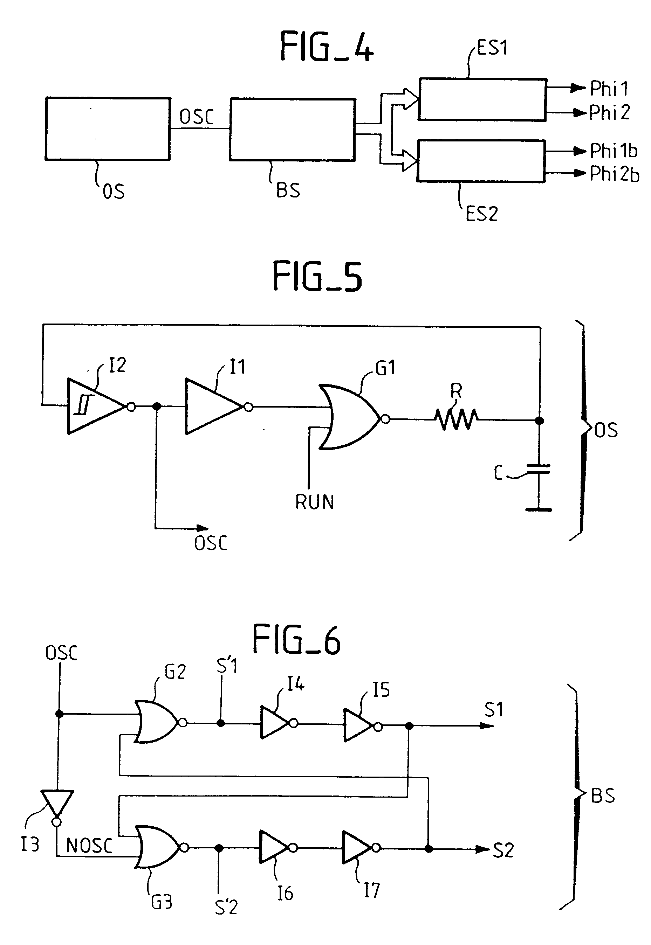

Sur la figure 4, on a représenté la constitution globale du circuit de commande de commutation utilisé dans une pompe de charge selon l'invention.

La pompe de charge est une pompe telle que celle de la figure 2, c'est-à-dire qu'elle comporte plusieurs étages en cascade comportant des transistors et des capacités, et un circuit de commande de commutation produisant quatre phases de commutation Phi1, Phi2, Phi1b, Phi2b, parmi lesquelles Phi1 et Phi2 sont deux phases complémentaires mais non recouvrantes, commutant entre deux valeurs qui sont sensiblement 0 et Vcc (Vcc étant la tension d'alimentation du circuit), et Phi1b et Phi2b sont des phases sensiblement synchronisées avec Phi1 et Phi2 respectivement et commutant entre deux valeurs de tension qui sont sensiblement 0 et VB avec VB supérieur à Vcc et de préférence supérieur à Vcc + Vt; Vt est la tension de seuil des transistors commandés par les phases Phi1b et Phi2b. On dira que Phi1 et Phi2 sont des signaux non bootstrapés, Phi1b et Phi2b étant des signaux bootstrapés pour pouvoir dépasser la tension Vcc. Le mot bootstrapé désigne, on le rappelle, une technique de production d'un signal logique artificiellement rehaussé par rapport à sa valeur normale, en général à l'aide d'une capacité qui est préchargée avant d'être interposée en série entre le signal à rehausser et la borne sur laquelle le signal rehaussé doit apparaître.

Le circuit de commande de commutation de la figure 4 produit donc les quatre phases Phi1, Phi2, Phi1b, Phi2b. Il comprend un oscillateur OS fournissant un signal périodique OSC à fréquence F, un circuit de séparation de phases, BS, pour produire à partir du signal OSC divers signaux complémentaires mais non recouvrants à la fréquence F, et enfin deux étages de sortie ES1 et ES2 utilisant ces signaux pour produire les signaux Phi1, Phi2 non bootstrapés (étage ES1) et les signaux Phi1b, Phi2b bootstrapés (étage ES2).

L'oscillateur est de préférence un oscillateur en anneau à très petit nombre de portes logiques, de préférence trois, pour avoir une stabilité optimale en fonction des variations de la tension d'alimentation. Le schéma préféré est celui de la figure 5. Il comprend de préférence un premier inverseur Il ayant une sortie reliée à une première entrée d'une porte NOR G1, la porte ayant une autre entrée commandée par un signal RUN; le signal RUN autorise ou interdit le fonctionnement de l'oscillateur. La sortie de la porte NOR est connectée par l'intermédiaire d'un circuit à constante de temps R,C à l'entrée d'un autre inverseur I2, de préférence un inverseur à seuil (trigger de Schmitt notamment); la sortie de l'inverseur I2, rebouclée sur l'entrée de l'inverseur I1, constitue la sortie de l'oscillateur, fournissant le signal OSC. La fréquence d'oscillation dépend essentiellement des valeurs respectives de R et C et du seuil de l'inverseur I2, et, dans une moindre mesure, des temps de basculement des inverseurs et portes, I1, I2, G1.

L'étage de séparation de phases BS est de préférence constitué comme à la figure 6. Il reçoit comme signal d'entrée le signal OSC fourni par l'oscillateur OS. Ce signal est inversé dans un inverseur I3 pour produire un signal NOSC; les fronts de montée du signal NOSC sont légèrement retardés par rapport aux fronts de descente du signal OSC, et de même les fronts de descente de NOSC sont légèrement retardés par rapport aux fronts de montée de OSC, à cause du retard inévitablement introduit par l'inverseur I3.

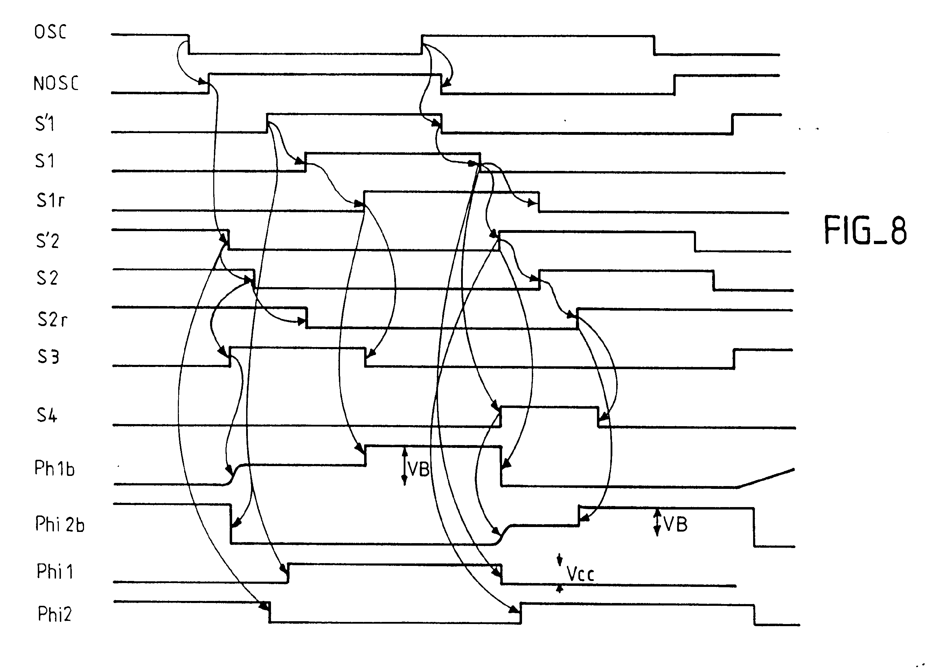

Les diagrammes temporels des signaux de commutation périodiques créés par les circuits de l'invention sont représentés à la figure 8 et on pourra s'y référer pour comprendre le fonctionnement du circuit. Sur ce diagramme, ainsi que dans les explications qui vont suivre, on a désigné volontairement par les mêmes signes de référence les noeuds de circuit et les signaux de commutation apparaissant sur ces noeuds.

Le circuit de séparation de phases BS, dont la fonction est de produire deux phases périodiques complémentaires non recouvrantes à la fréquence F, possède deux sorties S1 et S2. Elles sont non recouvrantes et complémentaires en ce sens que : le front de montée de S1 commence après la fin du front de descente de S2 et le front de descente de S1 qui suit apparaît avant le front de montée suivant de S2.

Le signal OSC est appliqué à une entrée d'une porte NOR G2 dont une autre entrée reçoit le signal S2. Inversement, le signal NOSC est appliqué à une porte NOR G3 dont une autre entrée reçoit le signal S1.

La sortie de la porte NOR G2 constitue encore une sortie S′1 de l'étage BS, sortie qui sera utilisée par la suite pour produire les signaux Phi1 et Phi2. Le signal S′1 a un front de montée déclenché par le front de descente de S2 et un front de descente déclenché par le signal OSC.

De même, la sortie de G3 constitue une autre sortie S′2 de l'étage. Le signal S′2 a un front de descente déclenché par le signal NOSC et un front de montée déclenché par le signal S1.

Le signal S′1 est inversé dans deux inverseurs successifs en cascade I4 et I5, l'entrée du premier étant relié à la sortie de la porte G2 et la sortie du deuxième constituant la sortie S1. De même, le signal S′2 est inversé dans deux inverseurs successifs en cascade I6 et I7, l'entrée du premier étant reliée à la sortie de la porte G3 et la sortie du deuxième étant reliée à la sortie S2.

Les signaux S1 et S2 sont retardés (par les deux inverseurs respectifs) par rapport aux signaux S′1 et S′2. Les signaux S′1 et S′2 constituent deux phases complémentaires non recouvrantes, de même que les signaux S1 et S2.

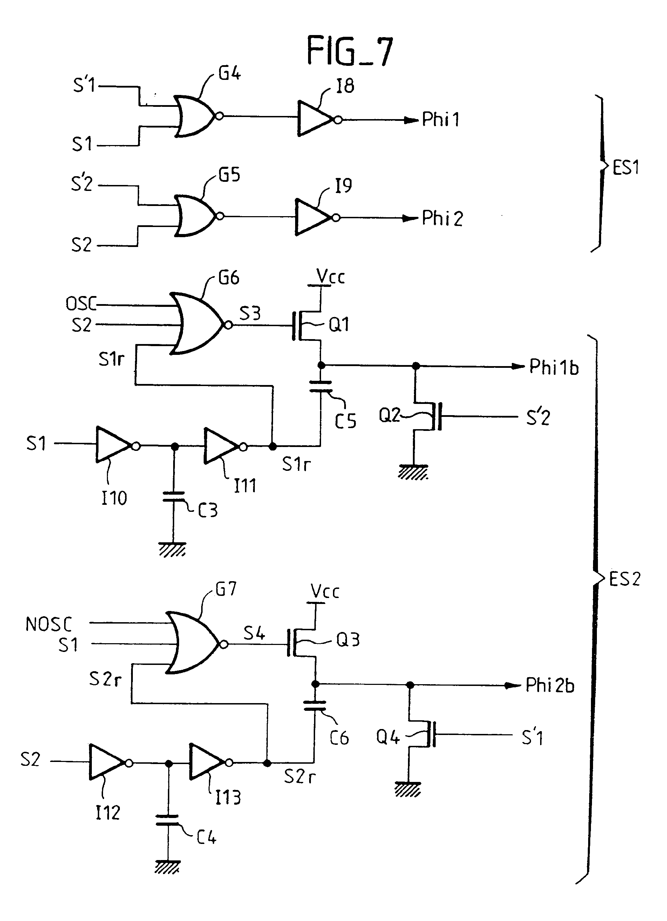

La constitution préférée des étages de sortie non-bootstrapés et bootstrapés est représentée à la figure 7.

L'étage non bootstrapé ES1, qui produit les signaux Phi1 et Phi2 reçoit comme entrées les quatre signaux S1, S′1, S2, S′2 de l'étage de séparation de phases. S1 et S′1 sont appliqués aux entrées d'une porte NOR G4; la sortie de la porte G4 est inversée dans un inverseur I8 pour produire le signal Phi1. Le signal Phi1 commute entre deux niveaux logiques O et Vcc, l'inverseur I8 étant alimenté par la tension Vcc.

De la même manière, les signaux S2 et S′2 sont appliqués à l'entrée d'une porte NOR G5 dont la sortie est inversée par un inverseur I9 pour produire le signal Phi2, commutant entre 0 et Vcc, complémentaire de Phi1 et non-recouvrant avec Phi1.

L'étage de sortie bootstrapé est légèrement plus complexe. Il reçoit comme entrées les signaux S1 et S2, ainsi que les signaux OSC et NOSC. Il reçoit par ailleurs aussi les signaux S′1 et S′2.

Le signal S1 est retardé grâce à un circuit à retard comportant par exemple deux inverseurs I10 et I11 en série, avec un capacité C3 connectée entre la sortie du premier inverseur (I10) et la masse, selon la configuration représentée à la figure 7. Le signal retardé apparaît à la sortie de I11 et est désigné par S1r. De la même façon, le signal S2 est retardé dans un circuit à retard identique (I12, I13, C4); le signal retardé est désigné par S2r. Le retard apporté est légèrement supérieur (grâce à la capacité C3 ou C4) au retard introduit par deux inverseurs en série.

L'étage ES2 comporte, outre les circuits à retard, deux portes NOR à trois entrées chacune, G6 et G7. La porte G6 reçoit le signal OSC, le signal S2 et le signal S1r. Sa sortie S3 fournit un créneau pendant que le signal OSC est au niveau bas; ce créneau présente un front de montée déclenché par le front de descente de S2, et un front de descente déclenché par le front de montée de S1r qui suit. Inversement, la porte NOR G7 reçoit NOSC, S1, et S2r. Sa sortie S4 fournit, pendant que OSC est au niveau haut, un créneau dont le front montant est déclenché par le front descendant de S1 et dont le front descendant est déclenché par le front montant de S2r.

Les créneaux S3 et S4 sont utilisés pour produire une phase de précharge des sorties Phi1b et Phi2b respectivement (sorties de l'étage ES2), avant une phase de commutation bootstrapée, déclenchée par les signaux S1r et S2r respectivement.

Pour cela, la sortie S3 de la porte NOR G6 est reliée à la grille de commande d'un transistor Q1 dont la source est reliée à l'alimentation Vcc et dont le drain est relié à la sortie Phi1b. Une capacité C5 est reliée entre la sortie S1r du circuit à retard (I10, I11, C3). Pendant le créneau S3, le transistor Q1 est rendu conducteur, Phi1b passe au niveau Vcc; comme le signal S1r est à ce moment au niveau bas, la capacité C5 tend à se charger à Vcc. Ensuite, vers la fin du créneau S3, à la fois le transistor Q1 se bloque, ce qui isole la sortie Phi1b de la borne Vcc, et S1r passe au niveau haut Vcc, ce qui porte brusquement le potentiel de Phi1b à environ Vcc grâce à la charge précédemment accumulée dans C5. L'effet bootstrap est donc obtenu sur le signal Phi1b.

Le signal Phi1b est remis à zéro par un transistor Q2 connecté entre la sorite Phi1b et la masse, ce transistor étant rendu conducteur par le signal S′2.

La production du signal bootstrapé Phi2b est identique, grâce à un ensemble Q3, C6, Q4 identique à l'ensemble Q1, C5, Q2 et recevant les signaux S2r, S′1, S4 au lieu de S1r, S′2, S3.

Avec la configuration selon l'invention, l'oscillateur OS n'est chargé que par l'inverseur I3, la porte G2 et la porte G6. Sa fréquence est peu affectée par cette faible charge.

Quant aux sorties Phi1, Phi2, Phi1b, Phi2b, elles sont chargées par les n étages de la pompe de charge, mais leur capacité à commander ces n étages ne dépend que du dimensionnement des éléments finaux (transistors et capacités) des étages de sortie, et ces éléments finaux n'interviennent pas sur la charge de l'oscillateur.

## Revendications

1. Pompe de charge utilisant plusieurs étages à transistors et capacités (T1, T2, T′1, T′2, C1, C2, C′1, C′2) avec un circuit de commande de commutation des transistors, caractérisée en ce que le circuit de commande de commutation comporte un oscillateur en anneau (OS) fournissant un signal à une fréquence F, suivi d'un étage de séparation de phases (BS) pour produire à partir de la sortie (OSC) de l'oscillateur deux phases de commutation non recouvrantes (S1, S′1; S2, S′2), à la fréquence de l'oscillateur, le circuit de commande comportant en outre un premier étage de sortie (ES1) pour fournir, à partir de signaux (S1, S′1, S2, S′2) issus de l'étage de séparation, deux signaux Phi1 et Phi2 non recouvrants et commutant entre une tension 0 et une tension Vcc, et un deuxième étage de sortie bootstrapé (ES2) pour fournir, à partir de signaux issus de l'étage de séparation, deux signaux Phi1b et Phi2b commutant sensiblement en synchronisme avec Phi1 et Phi2 mais entre une tension 0 et une tension VB supérieure à Vcc.

2. Pompe de charge selon la revendication 1, caractérisée en ce que l'oscillateur comporte un nombre de portes logiques égal à trois.

3. Pompe de charge selon la revendication 2, caractérisé en ce que l'une des portes logiques est un inverseur à seuil (I2).

## Patentansprüche

1. Ladungspumpe, bei der mehrere Stufen mit Transistoren und Kapazitäten (T1, T2, T′1, T′2, C1, C2, C′1, C′2) mit einem Steuerkreis zum Schalten der Transistoren verwendet werden, dadurch **gekennzeichnet,** daß der Schaltsteuerkreis einen Ringoszillator (OS) umfaßt, der ein Signal mit einer Frequenz (F) liefert, gefolgt von einer Stufe zur Phasentrennung (BS), um ausgehend vom Ausgangssignal (OSC) des Oszillators zwei nicht überlappende Schaltphasen (S1, S′1; S2, S′2) mit der Frequenz des Oszillators zu erzeugen, wobei der Steuerkreis außerdem eine erste Ausgangsstufe (ES1), um ausgehend von der Trennstufe ausgegebenen Signalen (S1, S′1, S2, S′2) zwei nicht überlappende und zwischen einer Spannung 0 und einer Spannung Vcc umschaltende Signale Phil und Phi2 zu liefern, und eine zweite Bootstrap-Ausgangsstufe (ES2) umfaßt, um ausgehend von von der Trennstufe ausgegebenen Signalen zwei Signale Philb und Phi2b zu liefern, die im wesentlichen synchron mit Phil und Phi2, aber zwischen einer Spannung 0 und einer Spannung VB größer als Vcc, umschalten.

2. Ladungspumpe nach Anspruch 1, dadurch **gekennzeichnet,** daß der Oszillator eine Anzahl von logischen Gliedern gleich drei umfaßt.

3. Ladungspumpe nach Anspruch 2, dadurch **gekennzeichnet,** daß das eine der logischen Glieder ein Schwellwert-Invertierglied (I2) ist.

## Claims

1. Charge pump using several stages of transistors and capacitors (T1, T2, T′1, T′2, C1, C2, C′1, C′2) with a circuit controlling the switching of the transistors, characterised in that the switching control circuit includes a ring oscillator (OS) supplying a signal at a frequency F, followed by a phase separation stage (BS) in order to produce, from the output (OSC) of the oscillator, two non-overlapping switching phases (S1, S′1; S2, S′2), at the frequency of the oscillator, the control circuit also including a first output stage (ES1) for supplying, from signals (S1, S′1, S2, S′2) coming from the separation stage, two non-overlapping signals Phil and Phi2 switching between a voltage 0 and a voltage Vcc, and a second bootstrapped output stage (ES2) for supplying, from signals coming from the separation stage, two signals Philb and Phi2b switching substantially in synchronism with Phi1 and Phi2 but between a voltage 0 and a voltage VB higher than Vcc.

2. Charge pump according to Claim 1, characterised in that the oscillator has a number of logic gates equal to three.

3. Charge pump according to Claim 2, characterised in that one of the logic gates is a threshold inverter (I2).
